# EUROPEAN PATENT APPLICATION

(11) **EP 1 895 581 A2**
(43) Date of publication of application: **05.03.2008**
(21) Application number: 07016857.0
(22) Date of filing: 28.08.2007
(51) Int. Cl.: H01L 21/68, H01L 21/304, C09J 7/02

(54) **Method of semiconductor wafer back processing, method of substrate back processing, and radiation-curable pressure-sensitive adhesive sheet**

(30) Priority: 29.08.2006 JP 2006232437
(71) Applicant: NITTO DENKO CORPORATION, Osaka (JP)
(72) Inventor: Shintani, Toshio, Ibaraki-shi Osaka (JP)
(74) Representative: Grünecker, Kinkeldey, Stockmair & Schwanhäusser Anwaltssozietät

(57) **Abstract**

The present invention relates to a method of semiconductor wafer back processing, which includes applying a radiation-curable pressure-sensitive adhesive sheet comprising a base film and a pressure-sensitive adhesive layer disposed on one side of the base film to a front side of a semiconductor wafer, the front side of the semiconductor wafer having recesses and protrusions; grinding the back side of the semiconductor wafer in such a state that the radiation-curable pressure-sensitive adhesive sheet is adherent to the front side of the semiconductor; and irradiating the pressure-sensitive adhesive sheet with a radiation to thereby cure the pressure-sensitive adhesive layer, followed by subjecting said ground back side of the semiconductor wafer to a surface treatment; and a radiation-curable pressure-sensitive adhesive sheet for use in the method of semiconductor wafer back processing.

## Description

### FIELD OF THE INVENTION

The present invention relates to a method of processing the back side of a semiconductor wafer or substrate. The invention further relates to a radiation-curable pressure-sensitive adhesive sheet for use in the back processing method.

### BACKGROUND OF THE INVENTION

In recent years, a technique has been increasingly employed in which a set of packages is mounted on a semiconductor IC chip in order to attain an even higher speed and further function advancement. Since such IC chips encounter the problem of heat buildup when used, a heat dissipation function is imparted thereto, for example, by subjecting the wafer back side to a treatment such as the vapor deposition or sputtering of a metal. Furthermore, there are cases where the wafer back side is subjected to a surface treatment conducted physically or with a chemical or to a surface treatment with dry etching using a plasma for the purpose of, for example, removing microcracks generated on the wafer back side during grinding to thereby heighten the strength of IC chips themselves. There also are cases where a plasma treatment or CVD treatment is conducted for the purpose of cleaning the wafer back side. On the other hand, the step of conducting reflow for mounting a glass for an image application or mounting a substrate for devices (IC chips) and the step of conducting a heat treatment after mounting them by die bonding in order to fix onto a lead frame are coming to be performed more and more.

Semiconductor wafer production steps generally include a back grinding step in which the back side of a wafer on which patterns have been formed is ground to a given thickness with a grinding apparatus, e.g., a back grinder. Such grinding is generally conducted after a protective sheet for semiconductor wafer processing is applied to the front side of the wafer for the purpose of, e.g., wafer protection. As the protective sheet for semiconductor wafer processing, use may be made of a pressure-sensitive adhesive sheet including a base and a pressure-sensitive adhesive layer disposed thereon. For example, a pressure-sensitive adhesive film, which includes a light-transmitting support and, formed on the support, a pressure-sensitive adhesive layer having the property of curing upon light irradiation to come to have a three-dimensional network structure, has been disclosed (see, JP-A-60-189938).

Furthermore, a method of wafer grinding, which includes applying an energy-ray-curable pressure-sensitive adhesive sheet to a front side of a wafer on which circuits have been formed; irradiating the pressure-sensitive adhesive sheet with an energy ray to cure the pressure-sensitive adhesive layer; and then grinding the back side of the wafer in the state of having the pressure-sensitive adhesive sheet adherent to the wafer front side, has been disclosed (see, JP-A-11-26406).

Even when the pressure-sensitive adhesive film is heated to such a degree as in the grinding, it encounters no problem at all. However, the surface treatment step after the grinding is usually conducted at a high temperature. Consequently, when a pressure-sensitive adhesive film such as that described above is used, adhesion between the wafer circuit side and the pressure-sensitive adhesive layer increases and the adhesion strength increases disadvantageously. Accordingly, when the adhesive film is finally stripped off, a stripping failure or wafer cracking occurs. Even when an energy-ray-curable pressure-sensitive adhesive sheet, e.g., an ultraviolet-curable pressure-sensitive adhesive sheet, is used in conducting a surface treatment, the polymerization initiator used in synthesizing the pressure-sensitive adhesive polymer or the photopolymerization initiator contained in the pressure-sensitive adhesive accelerates a reaction due to the surrounding heat, resulting in cured parts and uncured parts in the pressure-sensitive adhesive layer. This results in a problem that, even when an ultraviolet irradiation treatment is conducted just before the stripping of the pressure-sensitive adhesive sheet, a stripping failure or adhesive residue occurs to considerably reduce the yield.

### SUMMARY OF THE INVENTION

An object of the invention is to provide a method of semiconductor wafer back processing which does not cause wafer cracking, adhesive residue to the wafer, etc. and can secure a high yield. Another object of the invention is to provide a method of substrate back processing which does not cause substrate cracking, adhesive residue to the substrate, etc. and can secure a high yield. Still another object of the invention is to provide a radiation-curable pressure-sensitive adhesive sheet for use in the above-mentioned back processing methods.

The present inventors have made intensive studies in order to overcome the problems described above. As a result, they found that those objects can be accomplished with the following methods of back processing. The invention has been thus completed.

### DETAILED DESCRIPTION OF THE INVENTION

Namely, the present invention relates to:
a method of semiconductor wafer back processing, which comprises:
   applying a radiation-curable pressure-sensitive adhesive sheet comprising a base film and a pressure-sensitive adhesive layer disposed on one side of the base film to a front side of a semiconductor wafer, said front side of the semiconductor wafer having recesses and protrusions;
   grinding the back side of the semiconductor wafer in such a state that the radiation-curable pressure-sensitive adhesive sheet is adherent to the front side of the semiconductor; and
   irradiating the pressure-sensitive adhesive sheet with a radiation to thereby cure the pressure-sensitive adhesive layer, followed by subjecting said ground back side of the semiconductor wafer to a surface treatment.

By thus grinding the back side of a semiconductor wafer with the use of a radiation-curable pressure-sensitive adhesive sheet and irradiating the pressure-sensitive adhesive sheet with a radiation to cure the pressure-sensitive adhesive layer before the back side of the wafer is subjected to a surface treatment, the pressure-sensitive adhesive layer can be effectively inhibited from increasing in adhesion strength even when it is exposed to high-temperature conditions in the subsequent surface treatment step. Consequently, when the pressure-sensitive adhesive sheet is finally stripped off, troubles such as a stripping failure, wafer breakage, and adhesive residue to the wafer can be prevented and the pressure-sensitive adhesive sheet can be easily removed.

Furthermore, the invention relates to:
a method of substrate back processing, which comprises:
   applying a radiation-curable pressure-sensitive adhesive sheet comprising a base film and a pressure-sensitive adhesive layer disposed on one side of the base film to a front side of a substrate; and
   irradiating the pressure-sensitive adhesive sheet with a radiation to thereby cure the pressure-sensitive adhesive layer, followed by subjecting the back side of the substrate to a heat treatment.

By thus irradiating the pressure-sensitive adhesive sheet to cure the pressure-sensitive adhesive layer before the substrate back side is subjected to a heat treatment, the pressure-sensitive adhesive layer can be effectively inhibited from increasing in adhesion strength even when it is exposed to high-temperature conditions in the subsequent heat treatment step. Consequently, when the pressure-sensitive adhesive sheet is finally stripped off, troubles such as a stripping failure, substrate breakage, and adhesive residue to the substrate can be prevented and the pressure-sensitive adhesive sheet can be easily removed.

The invention still furthermore relates to a radiation-curable pressure-sensitive adhesive sheet for use in the above-mentioned methods of back processing, which comprises a base film and a pressure-sensitive adhesive layer, the pressure-sensitive adhesive layer containing as a component a radiation-curable acrylic polymer having a carbon-carbon double bond in the molecule thereof.

It is preferred that the pressure-sensitive adhesive layer of the radiation-curable pressure-sensitive adhesive sheet contain a radiation-curable oligomer as a component thereof The addition of a radiation-curable oligomer imparts plastic flowability to the pressure-sensitive adhesive and, hence, this pressure-sensitive adhesive sheet can be easily applied to a wafer, etc. Upon irradiation with a radiation, the oligomer crosslinks to form a substance having a low adhesiveness.
Consequently, this pressure-sensitive adhesive sheet can be easily stripped from the wafer, etc.

The radiation-curable pressure-sensitive adhesive sheet preferably has an adhesion strength as measured before irradiation with a radiation of 0.8 N/20 mm or higher and an adhesion strength as measured after irradiation with a radiation of lower than 0.8 N/20 mm. More preferably, the adhesion strength thereof as measured before irradiation with a radiation is 1.0 N/20 mm or higher and the adhesion strength thereof as measured after irradiation with a radiation is 0.7 N/20 mm or lower. In the case where the adhesion strength thereof as measured before irradiation with a radiation is lower than 0.8 N/20 mm, sufficient adhesion to a wafer cannot be obtained and, hence, water tends to penetrate into spaces during wafer back grinding. Therefore, there is a possibility that the pattern side of the wafer might be fouled and, in some cases, wafer grinding might become unstable to cause wafer breakage. On the other hand, in the case where the adhesion strength thereof as measured after irradiation with a radiation is 0.8 N/20 mm or higher, it is difficult to strip the pressure-sensitive adhesive sheet from a wafer or the like having a thickness of about 100 µm, and there is a possibility that troubles such as a stripping failure and the breakage of the wafer, etc. might arise. The adhesion strength is measured by the method which will be described in detail in the Examples.

Furthermore, it is preferred that the pressure-sensitive adhesive layer of the radiation-curable pressure-sensitive adhesive sheet have a modulus of elasticity at 25°C before irradiation with a radiation of 5 to 60,000 kPa, and the value (X) obtained by dividing the modulus of elasticity of the adhesive layer as determined before irradiation with a radiation by the modulus of elasticity of the adhesive layer as determined after irradiation with a radiation be from 8 × 10⁻⁵ to 0.35. More preferably, the pressure-sensitive adhesive layer has a modulus of elasticity at 25°C before irradiation with a radiation of 10 to 40,000 kPa, and the value (X) obtained by dividing the modulus of elasticity of the adhesive layer as determined before irradiation with a radiation by the modulus of elasticity of the adhesive layer as determined after irradiation with a radiation is from 1 × 10⁻⁴ to 0.1. In the case where the pressure-sensitive adhesive layer has a modulus of elasticity at 25°C before irradiation with a radiation of lower than 5 kPa, this pressure-sensitive adhesive layer is so soft that there is a high possibility that the pressure-sensitive adhesive sheet might have reduced shape stability and deform during long-term storage or under load. Moreover, this pressure-sensitive adhesive may be forced out to foul the wafer or substrate. On the other hand, in the case where the pressure-sensitive adhesive layer has a modulus of elasticity at 25°C before irradiation with a radiation of higher than 60,000 kPa, this pressure-sensitive adhesive layer has poor conformability to recesses and protrusions on the wafer front side and, hence, water tends to penetrate into spaces during wafer back grinding. There is hence a possibility that the pattern side of the wafer might be fouled or wafer breakage might occur. In the case where X is smaller than 8 × 10⁻⁵, this pressure-sensitive adhesive layer is brittle and tends to leave an adhesive residue. In the case where X is higher than 0.35, this pressure-sensitive adhesive layer is less apt to undergo curing shrinkage and tends to cause a stripping failure. The modulus of elasticity is determined by the method which will be described in detail in the Examples.

The radiation-curable pressure-sensitive adhesive sheet of the invention includes a base film and a radiation-curable pressure-sensitive adhesive layer for application to a wafer or substrate. An interlayer constituted of, e.g., a resin, a pressure-sensitive adhesive layer of the non-radiation-curable type, or a pressure-sensitive adhesive layer differing in components from the above-mentioned radiation-curable pressure-sensitive adhesive layer may be disposed between the base film and the pressure-sensitive adhesive layer. The radiation-curable pressure-sensitive adhesive sheet may be in a label form or may be wound into a roll. According to the necessity, a separator may be disposed on the pressure-sensitive adhesive layer.

As the pressure-sensitive adhesive constituting the radiation-curable pressure-sensitive adhesive layer, a conventional one can be used without particular limitations. The pressure-sensitive adhesive can be prepared by suitably combining a base polymer composition, a proportion of a radiation-curable monomer ingredient or oligomer ingredient, etc. As the radiation-curable pressure-sensitive adhesive, use may be made of one which decreases in adhesion strength upon irradiation with a radiation. Examples of the radiation include X-rays, electron beams, and ultraviolet. It is, however, preferred to use ultraviolet from the standpoint of ease of handling.

As the pressure-sensitive adhesive, use may be made of an appropriate pressure-sensitive adhesive selected from, e.g., acrylic pressure-sensitive adhesives, silicone pressure-sensitive adhesives, and rubber-based pressure-sensitive adhesives. One pressure-sensitive adhesive or a mixture of two or more pressure-sensitive adhesives may be used. From the standpoints of adhesion to a semiconductor wafer or substrate, ease of regulating adhesion strength, etc., it is preferred to use an acrylic pressure-sensitive adhesive containing an acrylic polymer as a base polymer.

Examples of the acrylic polymer include acrylic polymers obtained from one or more monomer ingredients selected from alkyl esters of (meth)acrylic acid (e.g., linear or branched alkyl esters in which the alkyl group has 1 to 30, especially 4 to 18 carbon atoms, such as the methyl ester, ethyl ester, propyl ester, isopropyl ester, butyl ester, isobutyl ester, s-butyl ester, t-butyl ester, pentyl ester, isopentyl ester, hexyl ester, heptyl ester, octyl ester, 2-ethylhexyl ester, isooctyl ester, nonyl ester, decyl ester, isodecyl ester, undecyl ester, dodecyl ester, tridecyl ester, tetradecyl ester, hexadecyl ester, octadecyl ester, and eicosyl ester) and cycloalkyl esters of (meth)acrylic acid (e.g., the cyclopentyl ester and cyclohexyl ester). The term " (meth)acrylic acid ester" means an acrylic acid ester and/or an methacrylic acid ester. The term "(meth)" in the invention has the same meaning in every case.

The acrylic polymer may optionally contain units derived from one or more other monomer ingredients copolymerizable with those alkyl or cycloalkyl esters of (meth)acrylic acid for the purpose of modifying adhesiveness, cohesive force, heat resistance, etc.

Examples of such monomer ingredients include carboxyl-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfo-containing monomers such as styrenesulfonic acid, arylsulfonic acids, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; phosphate-group-containing monomers such as 2-hydroxyethyl acryloylphosphate; and acrylamide and acrylonitrile. These copolymerizable monomer ingredients can be used alone or in combination of two or more thereof.

The amount of those copolymerizable monomers to be used is preferably up by weight or less, more preferably 5 to 15% by weight, based on all monomer ingredients. When the copolymerizable monomers are used in an amount within that range, a better balance among adhesiveness, cohesive force, etc. tends to be obtained.

In producing the acrylic polymer, a polyfunctional monomer can also be optionally used for crosslinking the polymer. Examples of the polyfunctional monomer include 1,4-butanediol di(meth)acrylate, hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, tetramethylolmethane tetra(meth)acrylate, trimethylolpropane tri(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, epoxy (meth)acrylates, polyester (meth)acrylates, and urethane (meth)acrylates. These polyfunctional monomers also may be used alone or in combination of two or more thereof The amount of the polyfunctional monomer to be used is preferably 30% by weight or less, more preferably 0.5 to 20% by weight, based on all monomer ingredients from the standpoints of pressure-sensitive adhesive properties, etc.

The acrylic polymer may have a crosslinked structure. A crosslinked structure can be formed, for example, by polymerizing a monomer mixture containing the polyfunctional monomer in the presence of a crosslinking agent. By using an acrylic polymer having a crosslinked structure, the shape retention of the pressure-sensitive adhesive layer itself is improved and the pressure-sensitive adhesive sheet can hence be prevented from deforming. Accordingly, this pressure-sensitive adhesive sheet can retain a flat state.

The acrylic polymer may be obtained by polymerizing one of the monomers enumerated above or a mixture of two or more monomers selected from those. The polymerization may be conducted by any of solution polymerization, emulsion polymerization, bulk polymerization, suspension polymerization, and the like. From the standpoint of preventing the fouling of semiconductor wafers, etc., it is preferred that the content of low-molecular substrates in the pressure-sensitive adhesive layer be low. From this standpoint, the number-average molecular weight of the acrylic polymer is preferably 200,000 or higher, more preferably about 200,000 to 3,000,000, especially preferably about 250,000 to 1,500,000.

The radiation-curable pressure-sensitive adhesive to be used preferably is a radiation-curable pressure-sensitive adhesive of the addition type which contains a general pressure-sensitive adhesive and a radiation-curable monomer ingredient or oligomer ingredient incorporated therein; or a radiation-curable pressure-sensitive adhesive of the internal type which contains a base polymer which has a carbon-carbon double bond in any of the polymer side chains, main chain, and main-chain ends. The radiation-curable pressure-sensitive adhesive of the internal type is preferred because an oligomer ingredient or the like which is a low-molecular ingredient are not necessarily contained therein or is not contained in a large amount and, hence, this pressure-sensitive adhesive does not suffer migration of an oligomer ingredient or the like with the lapse of time and can form a pressure-sensitive adhesive layer having a stable layer structure.

As the base polymer having a carbon-carbon double bond, one which has a carbon-carbon double bond and has pressure-sensitive adhesive properties can be used without particular limitations. Preferred as such a base polymer is one having an acrylic polymer as a basic skeleton. Examples of the basic acrylic polymer skeleton include the acrylic polymers enumerated above as examples.

Methods for introducing a carbon-carbon double bond into any of the aforementioned acrylic polymers are not particularly limited, and various methods can be employed. However, to introduce a carbon-carbon double bond into polymer side chains is easy in molecular design. Examples thereof include a method in which a monomer having a functional group is copolymerized beforehand with an acrylic polymer and a compound having a functional group reactive with that functional group and further having a carbon-carbon double bond is thereafter condensed or additive-reacted with the polymer while maintaining the radiation curability of the carbon-carbon double bond.

Examples of combinations of those functional groups include a combination of carboxy and epoxy, combination of carboxy and aziridyl, and combination of hydroxyl and isocyanate. Preferred of these functional-group combinations is a combination of hydroxyl and isocyanate from the standpoint of ease of following the reaction. So long as such a functional-group combination which yields an acrylic polymer having a carbon-carbon double bond is used, each functional group may be possessed by either of the acrylic polymer and the compound. However, in that preferred combination, it is preferred that the acrylic polymer have hydroxyl groups and the compound have an isocyanate group.

In this case, examples of the isocyanate compound having a carbon-carbon double bond include methacryloylisocyanate, 2-methacryloyloxyethyl isocyanate, and m-isopropenyl-α,α-dimethylbenzyl isocyanate. As the acrylic polymer, use may be made of one obtained by copolymerizing any of the aforementioned hydroxyl-containing monomers and ether compounds such as 2-hydroxyethyl vinyl ether, 4-hydroxybutyl vinyl ether, and diethylene glycol monovinyl ether.

It is preferred that a radiation-curable oligomer be added to the radiation-curable pressure-sensitive adhesive so long as the properties of the adhesive are not impaired. Examples of the radiation-curable oligomer include various oligomers including urethane, polyether, polyester, polycarbonate, and polybutadiene oligomers. Such an oligomer having a (weight-average) molecular weight of about 100 to 30,000 is suitable. The amount of the radiation-curable oligomer to be incorporated is preferably 30 parts by weight or less, more preferably 10 parts by weight or less, per 100 parts by weight of the base polymer constituting the pressure-sensitive adhesive such as an acrylic polymer.

A photopolymerization initiator is incorporated into the radiation-curable pressure-sensitive adhesive in the case where the adhesive is to be cured with ultraviolet or the like. Examples of the photopolymerization initiator include α-ketol compounds such as 4-(2-hydroxyethoxy)phenyl 2-hydroxy-2-propyl ketone, α-hydroxy-α,α'-dimethylacetophenone, 2-methyl-2-hydroxypropiophenone, and 1-hydroxycyclohexyl phenyl ketone; acetophenone compounds such as methoxyacetophenone, 2,2-dimethoxy-2-phenylacetophenone, 2,2-diethoxyacetophenone, and 2-methyl-1-[4-(methylthio)phenyl]-2-morpholinopropane-1; benzoin ether compounds such as benzoin ethyl ether, benzoin isopropyl ether, and anisoin methyl ether; ketal compounds such as benzyl dimethyl ketal; aromatic sulfonyl chloride compounds such as 2-naphthalenesulfonyl chloride; optically active oxime compounds such as 1-phenyl-1,1-propanedione-2-(O-ethoxycarbonyl) oxime; benzophenone compounds such as benzophenone, benzoylbenzoic acid, and 3,3'-dimethyl-4-methoxybenzophenone; thioxanthone compounds such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; acylphosphinoxides; and acylphosphonates. The amount of the photopolymerization initiator to be incorporated is preferably about 1 to 10 parts by weight, more preferably about 3 to 5 parts by weight, per 100 parts by weight of the base polymer constituting the pressure-sensitive adhesive such as an acrylic polymer.

A conventional crosslinking agent such as an epoxy crosslinking agent, aziridine crosslinking agent, or isocyanate crosslinking agent may be added to the radiation-curable pressure-sensitive adhesive.

An ingredient which expands upon heating, such as heat-expandable fine particles, may be incorporated into the pressure-sensitive adhesive layer. The thermal expansion of the fine particles reduces the bonding area to facilitate stripping of the pressure-sensitive adhesive sheet.

The heat-expandable fine particles preferably has an average particle diameter of about 1 to 25 µm. The average particle diameter thereof is more preferably 5 to 15 µm, especially about 10 µm. As the heat-expandable fine particles, materials which expand upon heating can be used without particular limitations. However, use may be made of heat-expandable microcapsules obtained by encapsulating a suitable gasifying/expanding ingredient, such as butane, propane, or pentane, with shell walls of a copolymer of vinylidene chloride, acrylonitrile, or the like by the in-situ polymerization method or another method. Such heat-expandable microcapsules have advantages, for example, that they have excellent dispersibility in and mixability with the pressure-sensitive adhesive. Examples of commercial products of the heat-expandable microcapsules include Microsphere (manufactured by Matsumoto Yushi-Seiyaku Co., Ltd.).

The amount of the heat-expandable fine particles (heat-expandable microspheres) to be incorporated into the pressure-sensitive adhesive can be suitably determined according to the kind of the pressure-sensitive adhesive layer so that the adhesion strength of the pressure-sensitive adhesive layer can be reduced. In general, the amount thereof is about 1 to 100 parts by weight, preferably 5 to 50 parts by weight, more preferably 10 to 40 parts by weight, per 100 parts by weight of the base polymer.

Besides the ingredients described above, various known additives may be optionally incorporated into the pressure-sensitive adhesive. Examples of the additives include tackifiers, plasticizers, pigments, fillers, and antiaging agents.

The pressure-sensitive adhesive layer is composed of at least one layer and may be composed of two or more layers. In the case of employing two or more pressure-sensitive adhesive layers, they may be a combination of a non-radiation-curable pressure-sensitive adhesive layer and a radiation-curable pressure-sensitive adhesive layer. It is, however, necessary that the outermost pressure-sensitive adhesive layer to be applied to a wafer or substrate is a radiation-curable pressure-sensitive adhesive layer.

The thickness of the pressure-sensitive adhesive layer can be suitably determined so long as the property of holding and protecting a wafer or another adherend is not impaired. However, it is generally 1 to 100 µm, preferably 2 to 60 µm.

The material of the base film can be any of various materials without particular limitations. However, ones excellent in water resistance and heat resistance are preferred. Especially preferred are synthetic resin films which hardly shrink in a heat treatment and do not warp.

Examples of the material of the base film include polyolefins such as low-density polyethylene, linear polyethylene, medium-density polyethylene, high-density polyethylene, ultralow-density polyethylene, propylene random copolymers, propylene block copolymers, propylene homopolymer, polybutene, and polymethylpentene; ethylene/vinyl acetate copolymers, ionomer resins, ethylene/(meth)acrylic acid copolymers, ethylene/(meth)acrylic ester (random or alternating) copolymers, ethylene/butene copolymers, ethylene/hexene copolymers, polyurethanes, polyesters such as poly(ethylene terephthalate), poly(butylene terephthalate), and poly(ethylene naphthalate), polycarbonates, polyamides, polyimides, polystyrene, polyetheretherketones, poly(vinyl chloride), poly(vinylidene chloride), fluororesins, acrylic resins, cellulosic resins, and polymers obtained by crosslinking these polymers. A blend of two or more of these materials can be used according to the necessity. Furthermore, a thermoset resin, metal foil, paper, or the like may be used.

The polyolefins such as polyethylenes enumerated above increase in crosslink density upon irradiation with electron beams and whereby it comes to have enhanced heat resistance and be inhibited from thermal shrinkage. Consequently, the polyolefins are suitable for use in the case where the maximum temperature in the surface treatment or heat treatment exceeds 100°C.

Such base films may be obtained by known methods of film formation. For example, use may be made of the wet casting method, inflation extrusion method, T-die extrusion method, or the like. The base film may be used in an unstretched state, or may be one which has been stretched uniaxially or biaxially according to the necessity. The surface of the base film may be optionally subjected to a common physical or chemical treatment such as a matting treatment, corona discharge treatment, primer treatment, or crosslinking treatment (chemical crosslinking (silane)).

In producing each of such base films, materials of the same kind or different kinds can be suitably selected and used and a blend of two or more materials can be used according to the necessity. The base film may be composed of a single layer or two or more layers. In the case where the pressure-sensitive adhesive layer is to be cured, with the pressure-sensitive adhesive sheet adherent to a wafer or substrate, a base film which at least partly transmits a radiation such as X-rays, ultraviolet, or electron beams is used.

The thickness of the base film (total thickness in the case where the film is composed of two or more layers) may be about 10 to 300 µm, and is preferably about 50 to 200 µm.

For forming the interlayer, a material having softness which enables the interlayer to absorb recesses and protrusions present on a wafer surface may be used. Examples thereof include organic viscoelastic materials and thermoplastic resins. From the standpoints of the suitability of molecular design for wide use and productivity, organic viscoelastic materials are preferred. In particular, acrylic organic viscoelastic materials are preferred because the pressure-sensitive adhesive layer has satisfactory adhesion (anchoring) to these viscoelastic materials and the regulation of the modulus of elasticity thereof is easy.

Examples of the acrylic organic viscoelastic materials include acrylic polymers containing, as a main component, units derived from one or more alkyl esters of acrylic acid or methacrylic acid. Specific examples thereof include acrylic polymers each obtained from one or more of alkyl (meth)acrylates in which the alkyl has 4 to 12 carbon atoms, such as butyl (meth)acrylate, 2-ethylhexyl (meth)acrylate, isononyl (meth)acrylate, isooctyl (meth)acrylate, and lauryl (meth)acrylate.

Besides those monomer ingredients, copolymerizable monomers may be used in order to regulate the modulus of elasticity and gel content or for other purposes. It is preferred that the amount of the copolymerizable monomers be smaller than 30% by weight of all monomer ingredients. Specific examples of the copolymerizable monomers include alkyl esters of (meth)acrylic acid in which the alkyl groups each have 1 to 3 carbon atoms, such as methyl (meth)acrylate, ethyl (meth)acrylate, and isopropyl (meth)acrylate, alkyl esters of (meth)acrylic acid in which the alkyl groups each have 13 to 18 carbon atoms, such as tridecyl (meth)acrylate and stearyl (meth)acrylate, functional monomers such as itaconic acid, maleic anhydride, crotonic acid, maleic acid, fumaric acid, hydroxyalkyl (meth)acrylates, glycerol di(meth)acrylate, glycidyl (meth)acrylate, methylglycidyl (meth)acrylate, aminoethyl (meth)acrylate, and 2-(meth)acryloyloxyethyl isocyanate, polyfunctional monomers such as triethylene glycol di(meth)acrylate, ethylene glycol di(meth)acrylate, and trimethylolpropane tri(meth)acrylate, vinyl acetate, styrene, (meth)acrylonitrile, N-vinylpyrrolidone, (meth)acryloylmorpholine, cyclohexylmaleimide, isopropylmaleimide, and (meth)acrylamide.

The acrylic polymer may be obtained by polymerizing one of the monomers enumerated above or a mixture of two or more thereof. The polymerization may be conducted by any of solution polymerization, emulsion polymerization, bulk polymerization, suspension polymerization, and the like.

The number-average molecular weight of the organic viscoelastic material is not particularly limited so long as this material has the properties described above. However, it is preferably 10,000 to 2,000,000. In the case where the number-average molecular weight thereof is lower than 10,000, this viscoelastic material readily flows at high temperatures and, hence, the sheet tends to have poor shape retention. On the other hand, in the case where the number-average molecular weight thereof exceeds 2,000,000, the pressure-sensitive adhesive sheet tends to have poor conformability to recesses and protrusions in application.

The organic viscoelastic material can be used alone as the material for forming the interlayer, and it is also possible to use, as an organic viscoelastic material, an acrylic pressure-sensitive adhesive containing the acrylic polymer described above. Suitable additives such as a crosslinking agent, plasticizer, filler, pigment, and tackifier may be incorporated into this pressure-sensitive adhesive according to the necessity as in the case of the pressure-sensitive adhesive described above.

A thermoplastic resin is also usable as a material for forming the interlayer. The thermoplastic resin preferably is one having a melting point of 70°C or lower (according to differential thermal analysis). Preferably, the thermoplastic resin further has an MFR of 5 g/min or higher (according to JIS K6730). Examples thereof include polyethylene (PE); polybutene; polyolefin copolymers such as ethylene copolymers and modified polyolefin polymers, e.g., ethylene/ethyl acrylate copolymers (EEA), ethylene/acrylic ester/maleic anhydride copolymers (EEAMAH), ethylene/glycidyl methacrylate copolymers (EGMA), ethylene/methacrylic acid copolymers (EMAA), ethylene/vinyl acetate copolymers (EVA), and ionomer resins (IONO); thermoplastic elastomers such as butadiene-based elastomers (TPE-B), ester elastomers (TPE-E), and styrene/isoprene elastomers (TPE-SIS); thermoplastic polyesters, polyamide resins such as polyamide-12 type copolymers; polyurethanes; polystyrene resins; cellophane; polyacrylonitrile; acrylic resins such as copolymers of methyl methacrylate or an alkyl ester of (meth)acrylic acid; and poly(vinyl chloride) resins such as vinyl chloride/vinyl acetate copolymers.

The interlayer may contain other ingredients (additives). Examples of the ingredients include tackifiers, plasticizers, softeners, fillers, and antioxidants. The interlayer may be made to be radiation-curable by adding the radiation-reactive oligomer and initiator described above. The interlayer may be composed of one layer or two or more layers of the same or different kinds.

The thickness of the interlayer may be suitably determined according to the property of holding and protecting a wafer or the like, surface irregularities of the base film, and kind and thickness of the pressure-sensitive adhesive layer. However, it is generally about 5 to 600 µm, preferably about 10 to 550 µm.

A separator may be optionally disposed. Examples of the material constituting the separator include paper and films of synthetic resins such as polyethylene, polypropylene, and poly(ethylene terephthalate). The surface of the separator may have undergone a releasant treatment, such as a silicone treatment, long-chain-alkyl treatment, or fluorochemical treatment, so as to have enhanced releasability from the pressure-sensitive adhesive layer according to the necessity. The thickness of the separator is generally about 10 to 200 µm, preferably about 25 to 100 µm.

Processes for producing the radiation-curable pressure-sensitive adhesive sheet are not particularly limited. For example, the pressure-sensitive adhesive sheet can be produced by a method in which a pressure-sensitive adhesive is applied to a base film; or a method which includes applying a pressure-sensitive adhesive to a separator and then laminating it to a base film. In the case where the pressure-sensitive adhesive sheet includes an interlayer, examples of production processes include: a method in which an interlayer and a pressure-sensitive adhesive layer are formed in this order on a base film by coating fluid application; a method which includes forming an interlayer on a base film by coating fluid application, applying a pressure-sensitive adhesive to a separator, and then laminating these; and a method which includes applying a pressure-sensitive adhesive and an interlayer in this order to a separator and then laminating the resultant multilayer structure to a base film. Examples of techniques for applying a composition for interlayer formation and a pressure-sensitive adhesive composition include roll coating, screen coating, and gravure coating. The radiation-curable pressure-sensitive adhesive sheet can have any shape according to the applications thereof. For example, it is preferred to use the pressure-sensitive adhesive sheet which has been cut beforehand into the same shape as a wafer or the like.

In the case where the radiation-curable pressure-sensitive adhesive sheet is to be wound into a roll, ease of unwinding may be attained by forming a releasing layer on the other side of the base film (on the side which comes into contact with the pressure-sensitive adhesive layer in winding) without using a separator. The releasing layer may have undergone a releasant treatment such as a silicone treatment, long-chain-alkyl treatment, or fluorochemical treatment.

In the method of semiconductor wafer back processing of the invention, a step of applying a radiation-curable pressure-sensitive adhesive sheet containing a base film and a pressure-sensitive adhesive layer formed on one side thereof to a semiconductor wafer front side having recesses and protrusions is firstly conducted. This application step is conducted in an ordinary manner. Although the radiation-curable pressure-sensitive adhesive sheet to be used is not particularly limited, it is preferred to use the pressure-sensitive adhesive sheet described above. That pressure-sensitive adhesive sheet plastically deforms in accordance with the circuit recesses and protrusions on the wafer front side since it has flexibility before irradiation with a radiation, and the pressure-sensitive adhesive layer deforms while conforming to the circuit recesses and protrusions to thereby buffer the recesses and protrusions.

For example, the application of the pressure-sensitive adhesive sheet to the pattern side of a semiconductor wafer is conducted in the following manner. The semiconductor wafer is placed on a table so that the front side of the wafer, i.e., the side having recesses and protrusions, faces upward. The pressure-sensitive adhesive layer of the pressure-sensitive adhesive sheet is superposed on this wafer and applied thereto while pressing the pressure-sensitive adhesive sheet against the wafer with a pressing device such as a pressure roller. It is also possible to use a method in which the pressure-sensitive adhesive sheet is superposed on a semiconductor wafer in the arrangement shown above in a vessel capable of pressurizing (e.g., an autoclave) and the inside of this vessel is pressurized to thereby apply the pressure-sensitive adhesive sheet to the wafer. In this method, the pressure-sensitive adhesive sheet may be applied while being pressed with a pressing device. Furthermore, the pressure-sensitive adhesive sheet may be applied in a vacuum chamber in the same manner as described above. Methods of application should not be construed as being limited to these, and the pressure-sensitive adhesive sheet may be heated to about 30 to 150°C during application.

The front side of a semiconductor wafer generally has circuit patterns having recesses and protrusions of about 10 to 60 µm, a thick polyimide (5 to 20 µm) as a protective film for the wafer front side, defective-indicating marks (5 to 100 µm) for discriminating defective chips, and gold bumps (10 to 100 µm) or solder bumps (50 to 300 µm) for bump connection as a substitute for wire connection.

Subsequently, a step of grinding the back side of the semiconductor wafer in such a state that the pressure-sensitive adhesive sheet is adherent to the front side thereof is conducted. This grinding step can be conducted in an ordinary manner. The semiconductor wafer is ground until it comes to have a desired thickness.

The pressure-sensitive adhesive sheet is then irradiated with a radiation to cure the pressure-sensitive adhesive layer. When the pressure-sensitive adhesive layer after the grinding is irradiated in that state with a radiation, the pressure-sensitive adhesive layer cures in the state of buffering the circuit recesses and protrusions on the wafer front side. Although the kind and irradiation dose of the radiation are not particularly limited, it is preferred that the pressure-sensitive adhesive layer after curing have properties within the range shown above. In general, the irradiation dose in the case of using ultraviolet is about 50 to 2,000 mJ/cm² and the irradiation dose in the case of using electron beams is about 0.1 to 1,000 kGy.

After the pressure-sensitive adhesive layer is cured, the wafer back side which has been ground is subjected to a surface treatment, with the pressure-sensitive adhesive sheet adherent to the wafer front side. The surface treatment can be conducted in an ordinary manner. Examples of the surface treatment include vapor deposition of a metal, sputtering, CVD, plasma treatment, dry etching, and metallizing.

Since the surface treatment on the wafer back side is conducted in such a state that the pressure-sensitive adhesive layer cured is in the state of being tightly adherent to and fixed on the wafer front side, the pressure-sensitive adhesive tape does not separate from the wafer front side even when the surface treatment is conducted under high-temperature conditions. Consequently, the wafer front side can be perfectly protected during the surface treatment conducted under high-temperature conditions. In addition, since the pressure-sensitive adhesive layer neither deforms plastically nor increases in adhesion strength during the surface treatment, the pressure-sensitive adhesive tape can be easily stripped from the wafer front side after the surface treatment without damaging or fouling the wafer. Therefore, according to the semiconductor wafer back processing method of the invention, neither wafer cracking nor adhesive residue on the wafer occurs and a high yield can be secured.

On the other hand, in the substrate back processing method of the invention, a step of applying a radiation-curable pressure-sensitive adhesive sheet containing a base film and a pressure-sensitive adhesive layer formed on one side thereof to a substrate front side is firstly conducted. This application step is conducted in an ordinary manner. Examples of the substrate include glasses and devices (e.g., IC chips). Although the radiation-curable pressure-sensitive adhesive sheet to be used is not particularly limited, it is preferred to use the pressure-sensitive adhesive sheet described above.

Subsequently, the pressure-sensitive adhesive sheet is irradiated with a radiation to cure the pressure-sensitive adhesive layer in the manner described above.

Thereafter, the back side of the substrate is subjected to a heat treatment, with the pressure-sensitive adhesive sheet adherent to the substrate front side. In the case where the substrate is a glass, reflow processing in which the electrode parts of devices or PKGs are connected, for example, is a step corresponding to the heat treatment. In the case where the substrate is an IC chip, solder reflow processing, for example, is a step corresponding to the heat treatment.

Since the heat treatment on the substrate back side is conducted in such a state that the pressure-sensitive adhesive layer cured is in the state of being tightly adherent to and fixed on the substrate front side, the pressure-sensitive adhesive tape does not separate from the substrate front side even when the heat treatment is conducted under high-temperature conditions. Consequently, the substrate front side can be perfectly protected during the heat treatment conducted under high-temperature conditions. In addition, since the pressure-sensitive adhesive layer neither deforms plastically nor increases in adhesion strength during the heat treatment, the pressure-sensitive adhesive tape can be easily stripped from the substrate front side after the heat treatment without damaging or fouling the substrate. Therefore, according to the substrate back processing method, neither substrate cracking nor adhesive residue on the substrate occurs and a high yield can be secured.

### EXAMPLE

The invention will be explained below in more detail by reference to Examples. However, the invention should not be construed as being limited to the following Examples.

### Preparation of Pressure-Sensitive Adhesives

### (Radiation-Curable Pressure-Sensitive Adhesive A1)

Eighty parts by weight of butyl acrylate, 60 parts by weight of ethyl acrylate, and 15 parts by weight of 2-hydroxyethyl acrylate were copolymerized in ethyl acetate to obtain a solution of an acrylic polymer having a weight-average molecular weight of 1,300,000. To 100 parts by weight of this acrylic polymer solution (solid content, 25% by weight) was added 8.4 parts by weight of methacryloyloxyethyl isocyanate. The resultant mixture was reacted to obtain a radiation-curable pressure-sensitive adhesive A1.

### (Radiation-Curable Pressure-Sensitive Adhesive A2)

Fifty parts by weight of butyl acrylate, 20 parts by weight of methyl methacrylate, and 30 parts by weight of 2-hydroxyethyl acrylate were copolymerized in ethyl acetate to obtain a solution of an acrylic polymer having a weight-average molecular weight of 900,000. To 100 parts by weight of this acrylic polymer solution '(solid content, 25% by weight) was added 7.0 parts by weight of methacryloyloxyethyl isocyanate. The resultant mixture was reacted to obtain a radiation-curable pressure-sensitive adhesive A2.

### (Radiation-Curable Pressure-Sensitive Adhesive A3)

Ninety parts by weight of butyl acrylate, 7 parts by weight of 2-ethylhexyl acrylate, and 5 parts by weight of 2-hydroxyethyl acrylate were copolymerized in ethyl acetate to obtain a solution of an acrylic polymer having a weight-average molecular weight of 1,050,000. To 100 parts by weight of this acrylic polymer solution (solid content, 25% by weight) was added 3.0 parts by weight of methacryloyloxyethyl isocyanate. The resultant mixture was reacted to obtain a radiation-curable pressure-sensitive adhesive A3.

### (Radiation-Curable Pressure-Sensitive Adhesive A4)

Five parts by weight of butyl acrylate, 90 parts by weight of ethyl acrylate, 7 parts by weight of 2-ethylhexyl acrylate, and 5 parts by weight of 2-hydroxyethyl acrylate were copolymerized in ethyl acetate to obtain a solution of an acrylic polymer having a weight-average molecular weight of 1,050,000. To 100 parts by weight of this acrylic polymer solution (solid content, 25% by weight) was added 3.0 parts by weight of methacryloyloxyethyl isocyanate. The resultant mixture was reacted to obtain a radiation-curable pressure-sensitive adhesive A4.

### (Pressure-Sensitive Adhesive A5)

Fifty parts by weight of butyl acrylate, 50 parts by weight of 2-ethylhexyl acrylate, and 10 parts by weight of 2-hydroxyethyl acrylate were copolymerized in ethyl acetate to obtain a solution of an acrylic polymer having a weight-average molecular weight of 1,050,000. This acrylic polymer solution (solid content, 25% by weight) was used as a pressure-sensitive adhesive A5.

### EXAMPLE 1

The radiation-curable pressure-sensitive adhesive A1 (100 parts by weight) was mixed with 2 parts by weight of an acetophenone type photopolymerization initiator (Irgacure 184, manufactured by Ciba Geigy Ltd.) and 1 part by weight of a polyfunctional isocyanate compound (Coronate L, manufactured by Nippon Polyurethane Co., Ltd.) to prepare a radiation-curable pressure-sensitive adhesive composition B1. This composition B1 was applied to an EB-treated polyethylene film (thickness, 100 µm) in such an amount as to result in a dry thickness of 20 µm. The composition applied was dried at 120°C for 1 minute to obtain a radiation-curable pressure-sensitive adhesive sheet C1.

The radiation-curable pressure-sensitive adhesive sheet C 1 was applied to the front side of a semiconductor wafer (circuit plane gap, 30 µm; 8 inches; thickness, 725 µm) with a 5-kg rubber roller. The back side of this wafer was ground to a wafer thickness of 170 µm with a wafer grinder (DFG840, manufactured by Disco Corp.). Using UM-810 (manufactured by Nitto Seiki Inc.) equipped with a high-pressure mercury lamp (20 mW/cm²), the radiation-curable pressure-sensitive adhesive sheet C1 was irradiated with ultraviolet under the conditions of an irradiation distance of 10 cm and an integrated quantity of light of 100 mJ/cm². Thereafter, the wafer back side was cleaned by conducting a plasma treatment using RIE Series (manufactured by Advanced Plasma System) under the conditions of a CF₄ gas/O₂ mixing ratio of 10/90, output of 2,000 W, and treatment time of 5 minutes. In this treatment, the maximum temperature of the wafer back side was 150°C. Thereafter, the pressure-sensitive adhesive sheet was stripped from the wafer with HR-8500-II, manufactured by Nitto Seiki Inc. The results of the stripping test are shown in Table 1.

### EXAMPLE 2

A radiation-curable pressure-sensitive adhesive composition B2 was prepared and a radiation-curable pressure-sensitive adhesive sheet C2 was obtained therefrom in the same manners as in Example 1, except that the radiation-curable pressure-sensitive adhesive A2 was used in place of the radiation-curable pressure-sensitive adhesive A1. Wafer back grinding and back treatment were conducted in the same manners as in Example 1, except that the radiation-curable pressure-sensitive adhesive sheet C2 was used in place of the radiation-curable pressure-sensitive adhesive sheet C1. Thereafter, the pressure-sensitive adhesive sheet was stripped from the wafer with HR-8500-II, manufactured by Nitto Seiki Inc. The results of the stripping test are shown in Table 1.

### EXAMPLE 3

A radiation-curable pressure-sensitive adhesive composition B3 was prepared and a radiation-curable pressure-sensitive adhesive sheet C3 was obtained therefrom in the same manners as in Example 1, except that the radiation-curable pressure-sensitive adhesive A3 was used in place of the radiation-curable pressure-sensitive adhesive A1.

The radiation-curable pressure-sensitive adhesive sheet C3 was applied to the front side of a semiconductor wafer (circuit plane gap, 30 µm; 8 inches; thickness, 725 µm) with a 5-kg rubber roller. The back side of this wafer was ground to a wafer thickness of 100 µm with a wafer grinder (DFG840, manufactured by Disco Corp.). Using UM-810 (manufactured by Nitto Seiki Inc.) equipped with a high-pressure mercury lamp (20 mW/cm²), the radiation-curable pressure-sensitive adhesive sheet C3 was irradiated with ultraviolet under the conditions of an irradiation distance of 10 cm and an integrated quantity of light of 1,800 mJ/cm². Thereafter, the wafer back side was subjected to the vapor deposition of gold using a sputtering apparatus under the conditions of a treatment time of 3 minutes. In this treatment, the maximum temperature of the wafer back side was 85°C. Thereafter, the pressure-sensitive adhesive sheet was stripped from the wafer with HR-8500-II, manufactured by Nitto Seiki Inc. The results of the stripping test are shown in Table 1.

### EXAMPLE 4

A radiation-curable pressure-sensitive adhesive composition B4 was prepared and a radiation-curable pressure-sensitive adhesive sheet C4 was obtained therefrom in the same manners as in Example 1, except that the radiation-curable pressure-sensitive adhesive A4 was used in place of the radiation-curable pressure-sensitive adhesive A1. Wafer back grinding and back treatment were conducted in the same manners as in Example 3, except that the radiation-curable pressure-sensitive adhesive sheet C4 was used in place of the radiation-curable pressure-sensitive adhesive sheet C3. Thereafter, the pressure-sensitive adhesive sheet was stripped from the wafer with HR-8500-II, manufactured by Nitto Seiki Inc. The results of the stripping test are shown in Table 1.

### EXAMPLE 5

The radiation-curable pressure-sensitive adhesive A1 (100 parts by weight) was mixed with 2 parts by weight of an acetophenone type photopolymerization initiator (Irgacure 184, manufactured by Ciba Geigy Ltd.) and 2 parts by weight of a polyfunctional isocyanate compound (Coronate L, manufactured by Nippon Polyurethane Co., Ltd.) to prepare a radiation-curable pressure-sensitive adhesive composition B5. This composition B5 was applied to an EB-treated polyethylene film (thickness, 100 µm) in such an amount as to result in a dry thickness of 50 µm. The composition applied was dried at 120°C for 1 minute to obtain a radiation-curable pressure-sensitive adhesive sheet C5.

The radiation-curable pressure-sensitive adhesive sheet C5 was applied to the front side of a semiconductor wafer (circuit plane gap, 50 µm; 8 inches; thickness, 725 µm) with a 5-kg rubber roller. The back side of this wafer was ground to a wafer thickness of 120 µm with a wafer grinder (DFG840, manufactured by Disco Corp.). Using UM-810 (manufactured by Nitto Seiki Inc.) equipped with a high-pressure mercury lamp (20 mW/cm²), the radiation-curable pressure-sensitive adhesive sheet C5 was irradiated with ultraviolet under the conditions of an irradiation distance of 10 cm and an integrated quantity of light of 1,800 mJ/cm². Thereafter, the wafer back side was subjected to the vapor deposition of gold using a sputtering apparatus under the conditions of a treatment time of 3 minutes. In this treatment, the maximum temperature of the wafer back side was 85°C. Thereafter, the pressure-sensitive adhesive sheet was stripped from the wafer with HR-8500-II, manufactured by Nitto Seiki Inc. The results of the stripping test are shown in Table 1.

### EXAMPLE 6

A radiation-curable pressure-sensitive adhesive composition B6 was prepared and a radiation-curable pressure-sensitive adhesive sheet C6 was obtained therefrom in the same manners as in Example 5, except that the radiation-curable pressure-sensitive adhesive A2 was used in place of the radiation-curable pressure-sensitive adhesive A1. Wafer back grinding and back treatment were conducted in the same manners as in Example 1, except that a semiconductor wafer (circuit plane gap, 50 µm; 8 inches; thickness, 725 µm) was used in place of the semiconductor wafer (circuit plane gap, 30 µm; 8 inches; thickness, 725 µm) and that the radiation-curable pressure-sensitive adhesive sheet C6 was used in place of the radiation-curable pressure-sensitive adhesive sheet C1. Thereafter, the pressure-sensitive adhesive sheet was stripped from the wafer with HR-8500-II, manufactured by Nitto Seiki Inc. The results of the stripping test are shown in Table 1.

### EXAMPLE 7

A radiation-curable pressure-sensitive adhesive composition B7 was prepared in the same manner as in Example 5, except that the radiation-curable pressure-sensitive adhesive A3 was used in place of the radiation-curable pressure-sensitive adhesive A1. A radiation-curable pressure-sensitive adhesive sheet C7 was obtained in the same manner as in Example 5, except that a polyimide film (thickness, 100 µm) was used in place of the polyethylene film.

The radiation-curable pressure-sensitive adhesive sheet C7 was applied to the front side of a semiconductor wafer (circuit plane gap, 50 µm; 8 inches; thickness, 725 µm) with a 5-kg rubber roller. The back side of this wafer was ground to a wafer thickness of 130 µm with a wafer grinder (DFG840, manufactured by Disco Corp.). Using UM-810 (manufactured by Nitto Seiki Inc.) equipped with a high-pressure mercury lamp (20 mW/cm²), the radiation-curable pressure-sensitive adhesive sheet C7 was irradiated with ultraviolet under the conditions of an irradiation distance of 10 cm and an integrated quantity of light of 500 mJ/cm². Thereafter, the semiconductor wafer was diced into IC chips. These IC chips were mounted on a mother board using a solder reflow apparatus. The treatment time in this operation was 5 minutes and the maximum temperature of the back sides of the IC chips was 240°C. Thereafter, the pressure-sensitive adhesive sheet was stripped from the IC chips with HR-8500-II, manufactured by Nitto Seiki Inc. The results of the stripping test are shown in Table 1.

### COMPARATIVE EXAMPLE 1

A radiation-curable pressure-sensitive adhesive composition B6 was prepared and a radiation-curable pressure-sensitive adhesive sheet C6 was obtained therefrom in the same manners as in Example 5, except that the radiation-curable pressure-sensitive adhesive A2 was used in place of the radiation-curable pressure-sensitive adhesive A1.

The radiation-curable pressure-sensitive adhesive sheet C6 was applied to the front side of a semiconductor wafer (circuit plane gap, 50 µm; 8 inches; thickness, 725 µm) with a 5-kg rubber roller. The back side of this wafer was ground to a wafer thickness of 170 µm with a wafer grinder (DFG840, manufactured by Disco Corp.). The wafer back side was then cleaned by conducting a plasma treatment using RIE Series (manufactured by Advanced Plasma System) under the conditions of a CF₄ gas/O₂ mixing ratio of 10/90, output of 2,000 W, and treatment time of 5 minutes. In this treatment, the maximum temperature of the wafer back side was 150°C. Thereafter, using UM-810 (manufactured by Nitto Seiki Inc.) equipped with a high-pressure mercury lamp (20 mW/cm²), the radiation-curable pressure-sensitive adhesive sheet C6 was irradiated with ultraviolet under the conditions of an irradiation distance of 10 cm and an integrated quantity of light of 500 mJ/cm². The pressure-sensitive adhesive sheet was stripped from the wafer with HR-8500-II, manufactured by Nitto Seiki Inc. The results of the stripping test are shown in Table 1.

### COMPARATIVE EXAMPLE 2

The pressure-sensitive adhesive A5 (100 parts by weight) was mixed with 3 parts by weight of a polyfunctional isocyanate compound (Coronate L, manufactured by Nippon Polyurethane Co., Ltd.) to prepare a pressure-sensitive adhesive composition B8. This composition B8 was applied to an EB-treated polyethylene film (thickness, 100 µm) in such an amount as to result in a dry thickness of 50 µm. The composition applied was dried at 120°C for 1 minute to obtain a pressure-sensitive adhesive sheet C8.

The pressure-sensitive adhesive sheet C8 was applied to the front side of a semiconductor wafer (circuit plane gap, 50 µm; 8 inches; thickness, 725 µm) with a 5-kg rubber roller. The back side of this wafer was ground to a wafer thickness of 170 µm with a wafer grinder (DFG840, manufactured by Disco Corp.). Thereafter, the wafer back side was cleaned by conducting a plasma treatment using RIE Series (manufactured by Advanced Plasma System) under the conditions of a CF₄ gas/O₂ mixing ratio of 10/90, output of 2,000 W, and treatment time of 5 minutes. In this treatment, the maximum temperature of the wafer back side was 150°C. Thereafter, the pressure-sensitive adhesive sheet was stripped from the wafer with HR-8500-II, manufactured by Nitto Seiki Inc. The results of the stripping test are shown in Table 1.

### Evaluation Methods

### (180° Peel Adhesion strength)

The radiation-curable pressure-sensitive adhesive sheets having a width of 20 mm produced in Examples 1 to 7 and Comparative Example 1 and the pressure-sensitive adhesive sheet having a width of 20 mm produced in Comparative Example 2 each were respectively applied to a semiconductor silicon wafer mirror surface by rolling a 2-kg rubber roller forward and backward in a 65% RH atmosphere at 25°C. Each pressure-sensitive adhesive sheet applied was allowed to stand for 30 minutes and then peeled off with a universal tensile tester (TENSILON/RTM-100, manufactured by Orientec Co., Ltd.) under the conditions of a peel rate of 300 mm/min and a peel angle of 180° to measure the adhesion strength (N/20 mm). Furthermore, the radiation-curable pressure-sensitive adhesive sheets produced in Examples 1 to 7 were applied to a semiconductor silicon wafer and allowed to stand under the same conditions as described above. Thereafter, each sample was irradiated with ultraviolet from the radiation-curable pressure-sensitive adhesive sheet side using UM-810 (manufactured by Nitto Seiki Inc.) equipped with a high-pressure mercury lamp (20 mW/cm²) under the conditions of an irradiation distance of 10 cm and the integrated quantity of light shown in Table 1. The pressure-sensitive adhesive sheet was then examined for 180° peel adhesion strength in the same manner as described above. On the other hand, the radiation-curable pressure-sensitive adhesive sheet produced in Comparative Example 1 was applied to a semiconductor silicon wafer and allowed to stand under the same conditions as described above, and was then heat-treated at 130°C for 5 minutes. Thereafter, this sample was irradiated with ultraviolet from the radiation-curable pressure-sensitive adhesive sheet side using UM-810 (manufactured by Nitto Seiki Inc.) equipped with a high-pressure mercury lamp (20 mW/cm²) under the conditions of an irradiation distance of 10 cm and the integrated quantity of light shown in Table 1. This pressure-sensitive adhesive sheet was then examined for 180° peel adhesion strength in the same manner as described above. The results obtained are shown in Table 1.

### (Shear Modulus of Elasticity)

The pressure-sensitive adhesive compositions prepared in Examples 1 to 7 and Comparative Examples 1 and 2 each were applied to a polyethylene film (thickness, 100 µm) in such an amount as to result in a dry thickness of 3 mm and dried at 120°C for 1 minute to form a pressure-sensitive adhesive layer. Thus, radiation-curable pressure-sensitive adhesive sheets and a pressure-sensitive adhesive sheet were obtained. Using an elastometer (ARES, manufactured by Rheometrics, Inc.), the pressure-sensitive adhesive layer of each pressure-sensitive adhesive sheet was examined for the shear modulus of elasticity (kPa) under the conditions of an ω of 1 Hz, plate diameter Φ of 7.9 mm, strain of 1%, and examination temperature of 25°C. Furthermore, the pressure-sensitive adhesive layer of each of the pressure-sensitive adhesive sheets produced with the pressure-sensitive adhesive compositions prepared in Examples 1 to 7 was irradiated with ultraviolet using UM-810 (manufactured by Nitto Seiki Inc.) equipped with a high-pressure mercury lamp (20 mW/cm²) under the conditions of an irradiation distance of 10 cm and the integrated quantity of light shown in Table 1. Thereafter, the pressure-sensitive adhesive layer thus cured was examined for the shear modulus of elasticity (kPa) in the same manner as described above. On the other hand, the pressure-sensitive adhesive sheet produced with the pressure-sensitive adhesive composition prepared in Comparative Example 1 was heat-treated at 130°C for 5 minutes. Thereafter, this pressure-sensitive adhesive layer was irradiated with ultraviolet using UM-810 (manufactured by Nitto Seiki Inc.) equipped with a high-pressure mercury lamp (20 mW/cm²) under the conditions of an irradiation distance of 10 cm and the integrated quantity of light shown in Table 1. The pressure-sensitive adhesive layer thus cured was then examined for the modulus of shear elasticity (kPa) in the same manner as described above. The results obtained are shown in Table 1. Furthermore, the value (X) obtained by dividing the modulus of elasticity of each pressure-sensitive adhesive layer before the irradiation by the modulus of elasticity of the pressure-sensitive adhesive layer after the irradiation is shown in Table 1.

**Table 1**

| | 180° Peel Adhesion strength (N/20 mm) | | | Shear Modulus of Elasticity (kPa) | | | X | Stripping test |
|---|---|---|---|---|---|---|---|---|
| | Before UV irradiation | Integrated quantity of light (mJ/cm²) | After UV irradiation | Before UV irradiation | Integrated quantity of light (mJ/cm²) | After UV irradiation | | |
| Example 1 | 15.00 | 100 | 0.70 | 15 | 100 | 120000 | 1.25×10⁻⁴ | good |
| Example 2 | 10.80 | 100 | 0.45 | 200 | 100 | 50000 | 4.0×10⁻³ | good |
| Example 3 | 3.57 | 1800 | 0.10 | 5000 | 1800 | 80000 | 6.25×10⁻² | good |
| Example 4 | 8.20 | 1800 | 0.30 | 600 | 1800 | 100000 | 6.0×10⁻³ | good |
| Example 5 | 11.57 | 1800 | 0.62 | 170 | 1800 | 30000 | 5.6×10⁻³ | good |
| Example 6 | 7.30 | 100 | 0.28 | 750 | 100 | 700000 | 1.0×10⁻³ | good |
| Example 7 | 1.85 | 1800 | 0.14 | 20000 | 1800 | 60000 | 0.33 | good |
| Comparative Example 1 | 7.30 | 100 | 5.00 | 750 | 100 | 1500 | 0.5 | wafer breakage occurred |
| Comparative Example 2 | 1.30 | - | - | 38000 | - | - | - | stripping failure and adhesive residue occurred |

As apparent from Table 1, the method of semiconductor wafer back processing of the invention does not cause wafer cracking, adhesive residue to the wafer, etc. and can secure a high yield.

While the present invention has been described in detail and with reference to specific embodiments thereof, it will be apparent to one skilled in the art that various changes and modifications can be made therein without departing from the scope thereof

This application is based on Japanese patent application No. 2006-232437 filed August 29, 2006, the entire contents thereof being hereby incorporated by reference.

Further, all references cited herein are incorporated in their entireties.

## Claims

1. A method of semiconductor wafer back processing, which comprises:
applying a radiation-curable pressure-sensitive adhesive sheet comprising a base film and a pressure-sensitive adhesive layer disposed on one side of the base film to a front side of a semiconductor wafer, said front side of the semiconductor wafer having recesses and protrusions;
grinding the back side of the semiconductor wafer in such a state that the radiation-curable pressure-sensitive adhesive sheet is adherent to the front side of the semiconductor; and
irradiating the pressure-sensitive adhesive sheet with a radiation to thereby cure the pressure-sensitive adhesive layer, followed by subjecting said ground back side of the semiconductor wafer to a surface treatment.

2. The method according to claim 1, wherein the pressure-sensitive adhesive layer contains as a component a radiation-curable acrylic polymer having a carbon-carbon double bond in the molecule thereof.

3. The method according to claim 1, wherein the pressure-sensitive adhesive layer contains a radiation-curable oligomer as a component.

4. The method according to claim 1, wherein the pressure-sensitive adhesive layer has an adhesion strength as measured before irradiation with a radiation of 0.8 N/20 mm or higher and an adhesion strength as measured after irradiation with a radiation of lower than 0.8 N/20 mm.

5. The method according to claim 1, wherein the pressure-sensitive adhesive layer has a modulus of elasticity at 25°C before irradiation with a radiation of 5 to 60,000 kPa, and
wherein the value (X) obtained by dividing the modulus of elasticity of said adhesive layer as determined before irradiation with a radiation by the modulus of elasticity of said adhesive layer as determined after irradiation with a radiation is from 8 × 10⁻⁵ to 0.35.

6. A method of substrate back processing, which comprises:
applying a radiation-curable pressure-sensitive adhesive sheet comprising a base film and a pressure-sensitive adhesive layer disposed on one side of the base film to a front side of a substrate; and
irradiating the pressure-sensitive adhesive sheet with a radiation to thereby cure the pressure-sensitive adhesive layer, followed by subjecting the back side of the substrate to a heat treatment.

7. The method according to claim 6, wherein the pressure-sensitive adhesive layer contains as a component a radiation-curable acrylic polymer having a carbon-carbon double bond in the molecule thereof.

8. The method according to claim 6, wherein the pressure-sensitive adhesive layer contains a radiation-curable oligomer as a component.

9. The method according to claim 6, wherein the pressure-sensitive adhesive layer has an adhesion strength as measured before irradiation with a radiation of 0.8 N/20 mm or higher and an adhesion strength as measured after irradiation with a radiation of lower than 0.8 N/20 mm.

10. The method according to claim 6, wherein the pressure-sensitive adhesive layer has a modulus of elasticity at 25°C before irradiation with a radiation of 5 to 60,000 kPa, and wherein the value (X) obtained by dividing the modulus of elasticity of said adhesive layer as determined before irradiation with a radiation by the modulus of elasticity of said adhesive layer as determined after irradiation with a radiation is from 8 × 10⁻⁵ to 0.35.

11. A radiation-curable pressure-sensitive adhesive sheet for use in the method according to claim 1, which comprises a base film and a pressure-sensitive adhesive layer, said pressure-sensitive adhesive layer containing as a component a radiation-curable acrylic polymer having a carbon-carbon double bond in the molecule thereof

12. The radiation-curable pressure-sensitive adhesive sheet according to claim 11, wherein the pressure-sensitive adhesive layer contains a radiation-curable oligomer as a component.

13. The radiation-curable pressure-sensitive adhesive sheet according to claim 11, which has an adhesion strength as measured before irradiation with a radiation of 0.8 N/20 mm or higher and an adhesion strength as measured after irradiation with a radiation of lower than 0.8 N/20 mm.

14. The radiation-curable pressure-sensitive adhesive sheet according to claim 11, wherein the pressure-sensitive adhesive layer has a modulus of elasticity at 25°C before irradiation with a radiation of 5 to 60,000 kPa, and
wherein the value (X) obtained by dividing the modulus of elasticity of said adhesive layer as determined before irradiation with a radiation by the modulus of elasticity of said adhesive layer as determined after irradiation with a radiation is from 8 × 10⁻⁵ to 0.35.

15. A radiation-curable pressure-sensitive adhesive sheet for use in the method according to claim 6, which comprises a base film and a pressure-sensitive adhesive layer, said pressure-sensitive adhesive layer containing as a component a radiation-curable acrylic polymer having a carbon-carbon double bond in the molecule thereof.

16. The radiation-curable pressure-sensitive adhesive sheet according to claim 15, wherein the pressure-sensitive adhesive layer contains a radiation-curable oligomer as a component.

17. The radiation-curable pressure-sensitive adhesive sheet according to claim 15, which has an adhesion strength as measured before irradiation with a radiation of 0.8 N/20 mm or higher and an adhesion strength as measured after irradiation with a radiation of lower than 0.8 N/20 mm.

18. The radiation-curable pressure-sensitive adhesive sheet according to claim 15, wherein the pressure-sensitive adhesive layer has a modulus of elasticity at 25°C before irradiation with a radiation of 5 to 60,000 kPa, and
wherein the value (X) obtained by dividing the modulus of elasticity of said adhesive layer as determined before irradiation with a radiation by the modulus of elasticity of said adhesive layer as determined after irradiation with a radiation is from 8 × 10⁻⁵ to 0.35.
